# FASCICULE DE BREVET EUROPEEN

(11) **EP 2 077 467 B1**
(45) Date de publication et mention de la délivrance du brevet: **12.03.2014**
(21) Numéro de dépôt: 08172748.9
(22) Date de dépôt: 23.12.2008
(51) Int. Cl.: G03F 1/00

(54) **Procédé de fabrication de photomasques et dispositif pour sa mise en oeuvre**
Herstellungsverfahren von Fotomasken und Vorrichtung für dessen Umsetzung
Method for manufacturing photo masks and device for implementing same

(30) Priorité: 04.01.2008 FR 0850056; 05.03.2008 FR 0851427
(43) Date de publication de la demande: 08.07.2009
(73) Titulaire: Adixen Vacuum Products, 74000 Annecy (FR)
(72) Inventeur: Favre, Arnaud, Alcatel Vacuum Technology, 74009, ANNECY (FR); Davenet, Magali, Alcatel Vacuum Technology, 74009, ANNECY (FR); Foray, Jean-Marie, 74000, ANNECY (FR)
(74) Mandataire: Croonenbroek, Thomas Jakob

(56) Documents cités:
- EP-A- 1 777 587
- JP-A- 58 078 429
- US-A1- 2001 005 944

## Description

La présente invention se rapporte à un procédé de fabrication des photomasques, notamment employés dans la fabrication de composants microélectroniques aux dimensions submicroniques. Elle s'étend en outre au dispositif pour la mise en oeuvre de ce procédé.

Le micro-usinage des substrats semiconducteurs, notamment en silicium est actuellement réalisé par des techniques de gravure au plasma à partir d'un motif transféré sur le substrat à partir d'un masque. Un photomasque est équivalent à un négatif en photographie : il contient une information à imprimer sur un support. Il est utilisé généralement en transmission pour des insolations et impressions sur des substrats semiconducteurs. Différents paramètres dont la longueur d'onde de focalisation définissent la profondeur de la zone active qui est imprimée directement sur le substrat. En dehors de cette zone, les détails ne sont pas imprimés mais peuvent avoir un impact sur la transmission du photomasque. Les pollutions dans la zone active ont un effet direct sur l'image imprimée sur le substrat avec l'impression d'un défaut. Mais ils n'ont qu'un effet indirect sur cette image s'ils interviennent en dehors de cette zone, comme par exemple la diminution du contraste ou la réduction de la transmission du photomasque.
Par ailleurs, l'industrie du semi-conducteur cherche à réduire la dimension de l'image inscrite afin d'obtenir des composants électroniques toujours plus petits, intégrables et moins coûteux. Les dimensions des photomasques se réduisant, les exigences en matière de pollution deviennent de plus en plus strictes. Le photomasque est donc un élément clef, cher et complexe que l'on cherche à conserver propre et opérationnel.
La zone active des photomasques doit impérativement être exempte de toute particule, notamment dans le plan focal, car ces particules contaminantes créent un défaut qui s'imprime et se répète sur le substrat semiconducteur. A la fin de sa fabrication, le masque est nettoyé puis une pellicule est appliquée sur le photomasque afin de protéger sa face active d'éventuelles particules. La pellicule a pour but de protéger le photomasque pendant sa vie chez l'utilisateur. Le pelliculage consiste en un dépôt d'une membrane optique (surfaces multicouches parallèles) ayant une bonne transmission et un impact réduit sur les rayons optiques qui la traversent. Cette pellicule est déposée du coté de la face active du photomasque, et séparée de celle-ci par un espace. Les polluants susceptibles de se déposer sur la face active du photomasque vont ainsi se déposer sur la pellicule en dehors de la zone de focalisation (éloignement physique de la surface active). Ainsi ces polluants ne seront pas imprimés dans le transfert par lithographie : la pellicule ne protège pas directement des polluants particulaires mais permet de réduire leur impact sur l'image.
Le document US-2001/005944 s'est intéressé à l'élimination des contaminants gazeux provenant de l'atmosphère environnante, tels que CO₂ et H₂O, qui peuvent se trouver présents dans l'espace entre le photomasque et la pellicule. Ces contaminants sont particulièrement gênants car ils empêchent le bon déroulement de l'opération de photolithographie en inhibant la transmission de la radiation à 157nm qui est habituellement utilisée. La décontamination s'opère dans une enceinte étanche, sous vide ou sous gaz optiquement inerte, par exposition à un rayonnement UV, à un plasma, à de l'ozone, et/ou à la chaleur. Ce traitement a pour effet d'accélérer la désorption des gaz.

Cependant l'augmentation de l'énergie nécessaire à l'insolation pour la création de motifs de plus en plus petits a engendré un nouveau problème. Les gaz présents sous la pellicule, tels que l'ammoniac, le fluor et des composés volatils organiques, se recombinent sous l'effet de cette forte énergie pour engendrer des cristaux qui vont croître avec le temps. Ces cristaux qui apparaissent sous la pellicule, donc dans la zone focale, produisent des défauts dans la zone imprimée sur le substrat. Ces cristaux représentent un problème majeur car ils engendrent des défauts non prévisibles et nombreux sur les substrats et peuvent affecter plus de 20 % des photomasques actuels les plus avancés.
Une des réactions chimiques se produisant peut être schématisée par la formule suivante :

H₂SO₄ + NH₃ + hν → (NH₄)₂SO_{4 solide}

L'ammoniac NH₃ provient de multiples sources, mais essentiellement de l'activité humaine dans les zones de fabrication des photomasques et d'utilisation de ces photomasques. Dans le but de réduire le phénomène de croissance cristalline, les fabricants de semi-conducteurs et de photomasques ont investi massivement pour limiter l'ammoniac présent dans la salle blanche et ont défini des stratégies de stockage et de transport des photomasques sous environnement protégé pour diminuer leur contact avec l'ammoniac.

L'acide sulfurique H₂SO₄ est largement utilisé par les fabricants de photomasques dans les étapes de fabrication, et notamment au cours des opérations de gravure et décapage (« stripping » en anglais). Dans le cas le plus courant, la dernière étape de nettoyage, avant l'étape de pelliculage, nécessite des sulfates et génère des résidus sulfatés. La dernière étape de décapage, consistant à enlever la résine précédemment déposée et qui précède le nettoyage, génère aussi des résidus de sulfate. Ces résidus sulfatés emprisonnés sous la pellicule vont donc désorber, ce qui est la raison principale de l'apparition de ces cristaux chez les fabricants de puces électroniques. Les fabricants de photomasques s'efforcent de réduire la quantité de sulfates utilisée dans les étapes de nettoyage en modifiant les procédés ou en ajoutant des étapes visant à réduire la teneur en résidus de sulfate. Toutefois ces nouveaux procédés ou les techniques palliatives mises en place sont plus coûteux et moins efficaces, et il n'est pas possible de supprimer totalement l'utilisation de sulfates dans les étapes de fabrication.

La pellicule est mise en place après une étape de décapage suivie d'une étape de nettoyage. La dernière étape de nettoyage est effectuée dans une zone propre. Cette pellicule va permettre de garantir que les particules générées dans la salle blanche ou dans les équipements de production ne vont pas se poser sur la face active du photomasque.
Une des solutions palliatives consiste à inspecter périodiquement la surface active du photomasque. Dès l'apparition des premiers cristaux, le photomasque est renvoyé à son fabricant, La pellicule est enlevée, nettoyée puis une nouvelle pellicule est déposée sur le photomasque. Cette opération doit être effectuée par les fabricants de photomasques et non par les utilisateurs, ce qui provoque une perte de temps et des coûts supplémentaires importants de gestion des stocks liés à la durée d'utilisation raccourcie des photomasques.

Le problème le plus important aujourd'hui pour les fabricants de composants semiconducteurs est donc la disponibilité et la durée d'utilisation de ces photomasques pour la production de semiconducteurs. En effet ces photomasques sont un maillon majeur dans la fabrication des puces électroniques, et leur technicité accrue implique un coût de plus en plus important.
La présente invention a donc pour but de permettre une durée d'utilisation plus longue des photomasques en diminuant la fréquence des opérations de nettoyage

L'invention a aussi pour but de réduire le risque de dégradation du photomasque lié à la pollution par formation de cristaux dans le volume placé sous la pellicule.

L'invention a encore pour but de proposer un procédé permettant l'élimination des composés résiduels ammoniaqués et sulfatés résultant de la fabrication des photomasques.

L'objet de la présente invention est un procédé de fabrication de photomasque comportant au moins une étape de nettoyage du photomasque, au moins une étape de mise en place d'une pellicule de protection sur le photomasque. Le procédé comporte en outre au moins une étape d'élimination des résidus ammoniaqués et sulfatés entre l'étape de nettoyage et l'étape de mise en place de la pellicule. L'étape d'élimination des résidus ammoniaqués et sulfatés comprend les opérations suivantes :
- on place le photomasque dans une enceinte étanche,
- on soumet le photomasque à un rayonnement infrarouge, dont la longueur d'onde est ajustée entre des longueur d'onde courtes agissant en profondeur et des longueurs d'onde longue agissant en surface, afin d'éliminer les résidus ammoniaqués et sulfatés, le rayonnement infrarouge étant régulé par hachage de manière à ne pas excéder une température du photomasque de 300°C,
- on arrête le rayonnement infrarouge en laissant l'enceinte sous basse pression,
- on attend que la température du photomasque est atteigne une valeur au plus égale à 50°C,
- on rétablit la pression atmosphérique dans l'enceinte par injection d'un gaz propre non-réactif ou d'un gaz neutre, et
- on extrait le photomasque de l'enceinte.

De préférence les gaz sont pompés pendant une durée comprise entre 20 minutes et 5 heures.

Le rayonnement infrarouge (IR) accélère la désorption sélective des espèces visées, et en améliorer le rendement. Le pompage des gaz contenus dans l'enceinte afin d'y établir le vide, utilisé simultanément au rayonnement infrarouge, améliore sensiblement la désorption des résidus, et notamment permet de désorber la quasi-totalité des composés ammoniaqués et sulfatés issus des étapes de nettoyage et de décapage. L'élimination des résidus ammoniaqués et sulfatés permet la pose de la pellicule de protection sur un substrat parfaitement propre.

La longueur d'onde du rayonnement infrarouge est le paramètre principal influant sur la désorption qui s'effectuera plus ou moins en profondeur selon la longueur d'onde choisie. Des ondes de rayonnement infrarouge de longueur d'onde dite « courtes » vont entrer plus en profondeur dans le matériau que les ondes de longueur d'onde dite « moyenne » ou « longue » qui seront plus efficaces en surface.
Le rayonnement infrarouge devra être soigneusement contrôlé car il provoque un échauffement du photomasque dont la température ne doit pas excéder 300°C impérativement. Au-delà de 300°C, le photomasque est irréversiblement endommagé. La température peut être comprise entre 50°C et 300°C, de préférence entre 50°C et 150°C, et de préférence encore à une température voisine de 80°C, L'augmentation de la température résultant de l'application du rayonnement infrarouge contribue à l'accélération du phénomène de désorption par diffusion.
Avantageusement la pression atmosphérique est rétablie dans l'enceinte lorsque la température à l'intérieur de l'enceinte est inférieure ou égale à 50°C, ce qui peut nécessiter un temps d'attente après arrêt du rayonnement infrarouge.
Selon l'invention, un gaz propre est introduit avec un flux constant simultanément au pompage des gaz dans l'enceinte. La présence d'un tel gaz est susceptible d'accélérer la désorption de certains autres composés organiques.
La remontée en pression à l'intérieur de l'enceinte est réalisée de préférence par injection d'un gaz propre non-réactif, tel que l'air ou un gaz neutre comme l'azote ou l'argon.

Pour augmenter encore la performance, on peut utiliser le procédé d'élimination des résidus ammoniaqués et sulfatés non seulement après la dernière étape de nettoyage, mais également après d'autres étapes de fabrication précédant le nettoyage et mettant en oeuvre des résidus sulfatés, comme par exemple l'étape de décapage.

L'invention a encore pour objet un dispositif pour la mise en oeuvre du procédé précédemment décrit comprenant :
- une enceinte étanche contenant au moins un photomasque,
- on groupe de pompage pour installer et maintenir le vide à l'intérieur de l'enceinte,
- un système de maintien d'au moins un photomasque, placé à l'intérieur de l'enceinte étanche.
- des moyens de rayonnement infrarouge.
- un système d'injection de gaz.
   Le système de maintien peut avantageusement être conçu pour permettre le traitement simultané de plusieurs photomasques.
   Selon une variante de réalisation du dispositif, les parois internes de l'enceinte réfléchissent les ondes émises.
   Selon une autre variante de réalisation, le système d'injection de gaz comprend un ou plusieurs injecteurs en forme de douche.
   Selon une autre variante de réalisation, le système d'injection de gaz comprend un ou plusieurs filtres à particules.
   Le dispositif peut comprendre en outre une jauge de pression pour le contrôle de la pression à l'intérieur de l'enceinte.
   Le dispositif peut aussi comprendre une sonde de température pour mesurer la température du photomasque.
   D'autres caractéristiques et avantages de la présente invention apparaîtront au cours de la description suivante de modes de réalisation, donnée bien entendu à titre illustratif et non limitatif, et dans le dessin annexé sur lequel
- la figure 1 montre schématiquement les différentes étapes d'un mode de réalisation du procédé selon l'invention.
- la figure 2 montre schématiquement un exemple du positionnement des moyens de rayonnement infrarouge par rapport aux photomasques,
- la figure 3 représente une installation adaptée à la réalisation de l'étape d'élimination des résidus ammoniaqués et sulfatés,
- la figure 4 représente une variante d'une installation adaptée à la réalisation de l'étape d'élimination des résidus ammoniaqués et sulfatés,
- la figure 5 est une comparaison du taux de sulfates résiduel dans les photomasques en fin de fabrication.

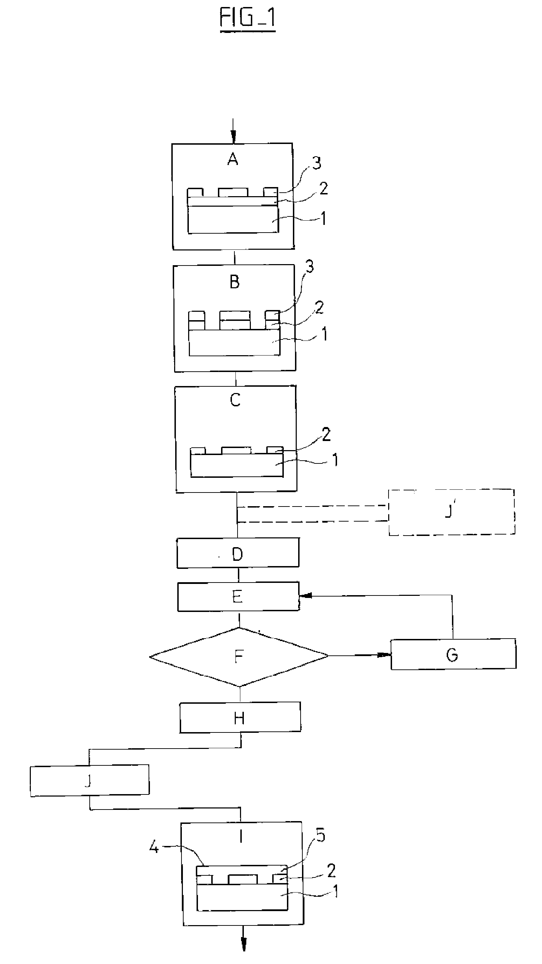

Un mode de réalisation du procédé de fabrication des photomasques, selon la présente invention, est schématiquement représenté sur la figure 1. La fabrication de photomasques comprend habituellement plusieurs étapes. Un substrat, par exemple en quartz **1** revêtu de chrome **2**, est recouvert d'une couche de résine **3** sur laquelle on reproduit le motif à graver, au moyen d'un faisceau laser ou électronique par exemple (étape **A**). L'étape **B** est une étape dé gravure durant laquelle le motif est gravé dans la couche de chrome **2**. Au cours d'une étape **C**, le photomasque, une fois gravé, est décapé par voie humide afin d'éliminer la résine **3** et les sous-produits de la réaction d'attaque. Le photomasque obtenu subit alors plusieurs opérations successives de nettoyage (étape **E**), de contrôle (étapes **D** et **F**) et de réparation éventuelle (étape **G**) au cours des étapes **D** à **G**. Un nettoyage final est effectué lors de l'étape **H.** Les conditions de nettoyage couramment utilisées impliquent la mise en oeuvre de sulfates dont il est nécessaire de se débarrasser avant l'étape **I** de recouvrement du photomasque par une pellicule protectrice **4**. En effet pour les raisons évoquées précédemment, la présence de sulfates dans la zone active **5** du photomasque sous la pellicule **4** doit absolument être évitée.
Une étape **J** d'élimination des résidus ammoniaqués et sulfatés, mettant en oeuvre la combinaison d'un rayonnement infrarouge et d'un pompage sous vide, est intercalée entre l'étape **H** de nettoyage et l'étape **I** de pelliculage de manière à supprimer la contamination du photomasque, notamment par les sulfates. Cette étape **J** comprend plusieurs opérations qui composent trois phases distinctes.
Au cours d'une première phase, le photomasque étant dans l'enceinte, les gaz présents dans l'enceinte sont pompés. Durant cette partie, le paramètre de contrôle est la vitesse de pompage. La pente de descente en pression est ajustée de manière à éviter la cristallisation de l'eau. Simultanément, les moyens de rayonnement infrarouge sont mis en route afin de permettre au système de contrôle de la longueur d'onde d'être préconditionné. Le photomasque est soumis au rayonnement infrarouge pour permettre d'accélérer le dégazage des contaminants, pendant que le pompage se poursuit.
La deuxième phase s'effectue sur un palier de température et de pression. Les trois paramètres température, pression et longueur d'onde IR sont interdépendants. La longueur d'onde du rayonnement infrarouge est ajustée pour permettre la désorption des résidus ammoniaqués et sulfatés. La pression permet de contrôler le seuil de désorption et la température est contrôlée afin de permettre l'ajustement de la régulation en longueur d'onde.
Le rayonnement infrarouge étant stoppé, la troisième phase débute par une remontée en pression dans l'enceinte dès que celle-ci a atteint une température égale ou inférieure à 50°C environ. La faible pression régnant dans l'enceinte contribue à abaisser la température. Le paramètre de contrôle de cette phase est la température. Un contrôle de la pression dans l'enceinte peut être aussi utilisé pour contrôler le refroidissement. La remontée en pression est réalisée au moyen d'un gaz propre non-réactif. En fin de cycle, la pression imposée de gaz propre est légèrement supérieure à la pression atmosphérique durant un court laps de temps de manière à favoriser l'adsorption du gaz propre à la surface du photomasque, ce qui permet de le protéger des contaminants extérieurs lorsqu'on le retire de l'enceinte. Le photomasque est refroidi à une température au plus égale à 50°C, de manière à ressortir de l'enceinte à une température voisine de la température ambiante, dans le but d'éviter la ré-adsorption des gaz présents dans l'atmosphère qui pourrait se produire lors de la baisse de température.

Dans un autre mode de réalisation, cette étape **J** d'élimination des résidus ammoniaqués et sulfatés peut aussi être placée avant l'étape de nettoyage **H**, notamment après certaines étapes impliquant la persistance de résidus sulfatés. Une étape d'élimination **J**' pourrait par exemple être intercalée en outre entre l'étape de décapage **C** et l'étape de contrôle **D.**

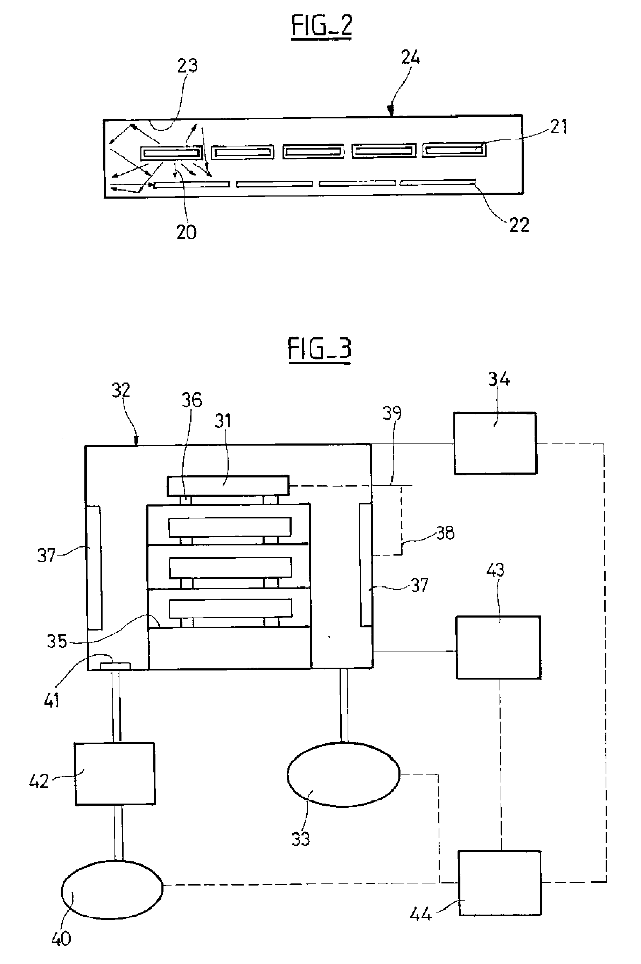

La figure 2 montre un exemple de la manière dont le rayonnement infrarouge **20** généré par les moyens de rayonnement **21** se réfléchissent sur les photomasques **22** d'une part et sur les parois internes **23** réfléchissantes de l'enceinte étanche **24** d'autre part. Les éléments chauffants peuvent être placés au-dessus des photomasques et /ou en-dessous des photomasques, ou intercalés entre deux couches de photomasques par exemple.
On privilégie l'utilisation d'un rayonnement infrarouge car la sélectivité vis à vis des espèces à éliminer et le rendement sous vide est élevé, En choisissant judicieusement les caractéristiques du rayonnement infrarouge **20**, comme par exemple la longueur d'onde, la désorption s'effectuera plus ou moins en profondeur. Des ondes de rayonnement infrarouge de longueur d'onde dite « courtes » vont entrer plus en profondeur dans le matériau que les ondes de longueur d'onde dite « moyenne » ou « longue » qui seront plus efficaces en surface.
Une température inférieure à 300°C, par exemple voisine de 80°C peut être appliquée sans endommager le photomasque. Avantageusement une régulation d'émission du rayonnement infrarouge par hachage, c'est à dire par application successive d'une tension V et d'uns tension nulle permettant d'obtenir des crêtes de puissance du rayonnement infrarouge, est utilisée, Cette régulation permet de contrôler l'échauffement des photomasques sans perdre les caractéristiques (longueur d'onde) du rayonnement infrarouge. Cette régulation permet aussi de faire varier la longueur d'onde du rayonnement infrarouge. En associant la régulation d'émission du rayonnement par hachage et la modification de la longueur d'onde du rayonnement infrarouge, il est ainsi possible de provoquer la désorption du photomasque à plusieurs niveaux de profondeur dans le matériau.

Pour apporter de l'énergie infrarouge au photomasque, une autre méthode est d'utiliser un générateur micro-onde, couplé à une barre métallique qui rayonnera des ondes infrarouges.

Dans le mode de réalisation de l'invention illustré sur la figure 3, les photomasques **31** (ne portant pas encore de pellicule) sont placés dans une enceinte **32** étanche maintenue sous vide au moyen d'un groupe de pompage 33. Une jauge de pression **34** permet de contrôler la pression a l'intérieur de l'enceinte **32**. Les photomasques sont placés sur des étagères **35** superposées, et ils sont supportés par des entretoises **36** non métalliques. Les photomasques sont soumis dans le cas présent à un rayonnement infrarouge au moyen d'un dispositif **37** disposé sur la paroi de l'enceinte **32,** par exemple un dispositif à micro-ondes tel que mentionné précédemment. Le dispositif **37** est piloté par une boucle de régulation **38** du rayonnement en fonction de la température du photomasque **31** mesurée par la sonde de température 39 associée. La géométrie et la disposition des éléments rayonnants **37** sont choisies afin d'obtenir une action homogène et optimisée sur toute la surface des photomasques **31.**
Avantageusement la surface de l'enceinte **32** peul être polie mécaniquement ou électrolytiquement, pour favoriser la réflexion du rayonnement infrarouge sur les photomasques **31**. La forme de l'enceinte **32** permet aussi de répartir le rayonnement infrarouge de manière homogène.
Une des contraintes importantes à laquelle est soumise l'installation est que la mise en oeuvre du procédé ne doit pas générer de particules. C'est pourquoi le système d'injection **40** de gaz comprend au moins un injecteur en forme de douche **41** permettant de diminuer la vitesse d'injection dans l'enceinte **32** sous vide. Le système d'injection **40** est en outre pourvu de filtres à particules **42**. Avantageusement le système d'injection **40** comprend un ou plusieurs injecteurs de gaz en forme de douche **41**, ce qui permet d'éviter les turbulences gazeuses lors de la remise de l'enceinte **32** à la pression atmosphérique. L'étape de remise à pression atmosphérique s'effectue suivant une équation mathématique du type : y = ax² + b dans laquelle y est le flux et x est la pression. Cette manière de procéder permet d'avoir une vitesse d'injection faible à faible pression, la contamination particulaire étant plus importante à faible pression.
Lors de l'étape d'élimination des résidus ammoniaqués et sulfatés, des moyens de mesure du dégazage **43** permettent de s'assurer du bon déroulement des opérations, par le suivi d'au moins un des paramètres suivants :
- la pression partielle des gaz.
- a pression limite du groupe de pompage **33**,
- le poids du photomasque **31**,
- la puissance réfléchie par les parois de l'enceinte **32.**
   Le groupe de pompage 3**3,**le système d'injection 40 et les moyens de mesure du dégazage **43** sont reliées à un dispositif **44** de contrôle et de pilotage dit PLC (pour « Programmable Logic Controller » en anglais).

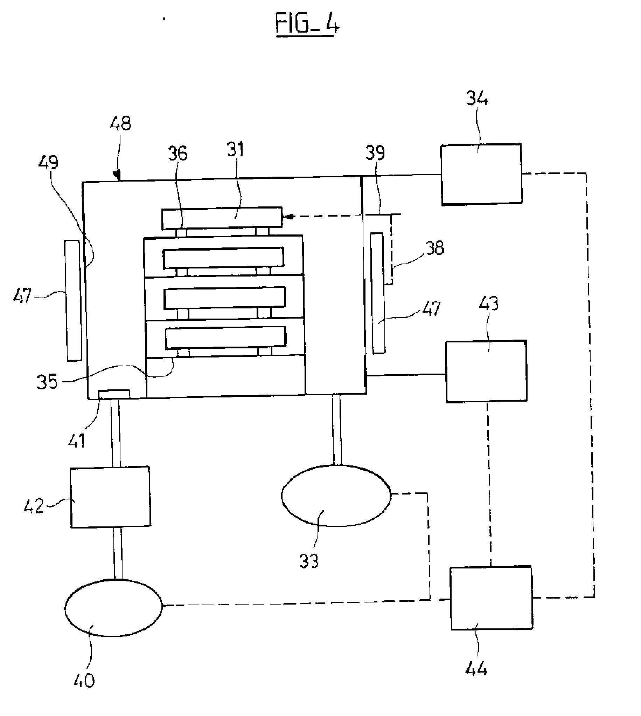

On considérera maintenant la figure 4 qui illustre un autre mode de réalisation d'une installation **31** adaptée à la réalisation de l'étape d'élimination des résidus ammoniaqués et sulfatés, dans laquelle le dispositif de rayonnement **47** est placé à l'extérieur de l'enceinte **48** sous vide. Une interface **49,** un hublot par exemple, ménagée dans la paroi de l'enceinte **48** laisse passer les ondes en direction du photomasque **31**. Le choix du matériau constitutif de l'interface **49** entre le dispositif de rayonnement **47** et les photomasques **31** est critique car ce matériau doit laisser passer les ondes destinées au photomasque **31**, sans poser de problème de dissipation du rayonnement qu'elles transportent. On choisira avantageusemenl le quartz.

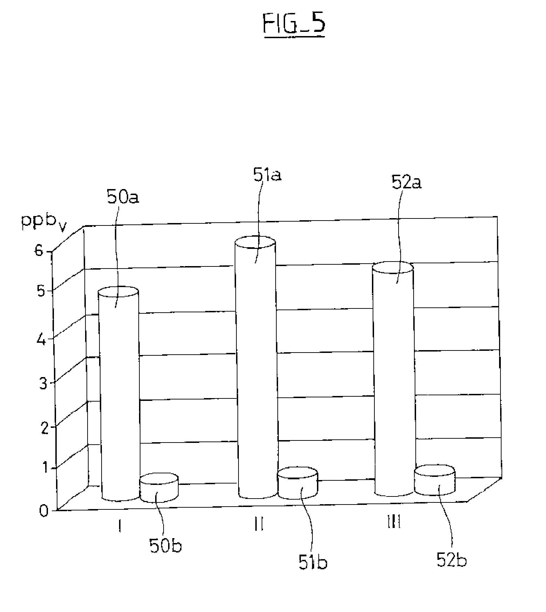

La figure 5 présente des résultats comparés de la mesure du taux de sulfates résiduel dans les photomasque, réalisée par le procédé de chromatographie ionique. Les taux de sulfates **50a, 51a,52a** résultent de l'opération de nettoyage des photomasques par trois variantes différentes I, II, III du procédé de nettoyage. Les taux de sulfates **50b, 51b, 52b** sont obtenus à l'issue de l'étape d'élimination selon un mode de réalisation de l'invention qui suit une étape de nettoyage pour chacune des trois variantes. La comparaison de ces résultats montre l'efficacité de l'étape d'élimination sur la teneur en sulfate des photomasques. L'objectif actuel des fabricants de photomasques pour les technologies 193nm est d'avoir un taux de sulfate inférieur à 1 ppbv (partie par billion volumique), pour ne pas avoir de problème de croissance cristalline chez leurs clients. La figure 5 montre que les valeurs atteintes **50b, 51b, 52b** grâce à l'invention sont largement en dessous de cet objectif.

## Revendications

1. Procédé de fabrication de photomasque comportant au moins une étape de nettoyage du photomasque, au moins une étape de mise en place d'une pellicule (4) de protection sur le photomasque, comportant au moins une étape d'élimination des résidus entre l'étape de nettoyage et l'étape de mise en place de la pellicule, **caractérisé en ce qu'**il comprend :
- on place le photomasque dans une enceinte étanche,
- on établit une basse pression dans l'enceinte étanche en pompant les gaz qu'elle contient,
- on soumet le photomasque à un rayonnement infrarouge, dont la longueur d'onde est ajustée selon la profondeur de désorption désirée entre des longueur d'onde courtes agissant en profondeur et des ondes de longueur d'onde longue agissant en surface, afin d'éliminer les résidus ammoniaqués et sulfatés, le rayonnement infrarouge étant régulé par hachage de manière à ne pas excéder une température du photomasque de 300°C,
- on arrête le rayonnement infrarouge en laissant l'enceinte sous basse pression,
- on attend que la température du photomasque atteigne une valeur au plus égale à 50°C,
- on rétablit la pression atmosphérique dans l'enceinte par injection d'un gaz propre non-réactif ou d'un gaz neutre, et
- on extrait le photomasque de l'enceinte.

2. Procédé selon la revendication 1, dans lequel les gaz sont pompés pendant une durée comprise entre 20 minutes et 5 heures.

3. Procédé selon l'une des revendications 1 et 2, dans lequel un gaz propre est introduit avec un flux constant simultanément au pompage.

4. Procédé selon la revendication 3, dans lequel le photomasque est chauffé à une température comprise entre 50°C et 300°C.

5. Procédé selon l'une des revendications précédentes, dans lequel la pression atmosphérique est rétablie par injection de gaz propre non-réactif.

6. Procédé selon l'une des revendications précédentes, comprenant en outre une étape d'élimination des résidus ammoniaqués et sulfatés après une autre étape de fabrication et avant ladite étape de nettoyage.

7. Dispositif pour la mise en oeuvre du procédé selon l'une des revendications précédentes comprenant :
- une enceinte étanche contenant au moins un photomasque,
- un groupe de pompage pour installer et maintenir le vide à l'intérieur de l'enceinte,
- un système de maintien d'au moins un photomasque, placé à l'intérieur de l'enceinte étanche,
- des moyens de rayonnement infrarouge,
- un système d'injection de gaz.

8. Dispositif selon la revendication 7, dans lequel les parois internes de l'enceinte réfléchissent les ondes émises.

9. Dispositif selon l'une des revendications 7 et 8, dans lequel le système d'injection de gaz comprend au moins un injecteur en forme de douche et au moins un filtre à particules.

## Patentansprüche

1. Verfahren zur Fertigung einer Fotomaske, das mindestens einen Schritt des Reinigens der Fotomaske, mindestens einen Schritt des Auflegens eines Schutzfilms (4) auf die Fotomaske aufweist, das mindestens einen Schritt des Entfernens der Reste zwischen dem Reinigungsschritt und dem Schritt des Auflegens des Films aufweist, **dadurch gekennzeichnet, dass** es enthält:
- das Anordnen der Fotomaske in einer dichten Kammer,
- den Aufbau eines Niederdrucks in der dichten Kammer durch Abpumpen der Gase, die sie enthält,
- das Aussetzen der Fotomaske einer Infrarotstrahlung, deren Wellenlänge entsprechend der gewünschten Desorptionstiefe zwischen in der Tiefe wirkenden kurzen Wellenlängen und an der Oberfläche wirkenden langen Wellenlängen eingestellt wird, um die ammoniakhaltigen und sulfathaltigen Reste zu entfernen, wobei die Infrarotstrahlung durch Zerhacken geregelt wird, um eine Temperatur der Fotomaske von 300°C nicht zu überschreiten,
- das Anhalten der Infrarotstrahlung, indem die Kammer unter Niederdruck gelassen wird,
- das Abwarten, bis die Temperatur der Fotomaske einen Wert höchstens gleich 50°C erreicht,
- die Wiederherstellung des Atmosphärendrucks in der Kammer durch Injektion eines nicht reaktiven sauberen Gases oder eines Schutzgases, und
- die Entnahme der Fotomaske aus der Kammer.

2. Verfahren nach Anspruch 1, wobei die Gase während einer Dauer zwischen 20 Minuten und 5 Stunden abpumpt werden.

3. Verfahren nach einem der Ansprüche 1 und 2, wobei gleichzeitig mit dem Abpumpen ein sauberes Gas in einem konstanten Fluss eingeführt wird.

4. Verfahren nach Anspruch 3, wobei die Fotomaske auf eine Temperatur zwischen 50°C und 300°C erwärmt wird.

5. Verfahren nach einem der vorhergehenden Ansprüche, wobei der Atmosphärendruck durch Injektion eines nicht reaktiven sauberen Gases wiederhergestellt wird.

6. Verfahren nach einem der vorhergehenden Ansprüche, das außerdem einen Schritt des Entfernens der ammoniakhaltigen und sulfathaltigen Reste nach einem weiteren Fertigungsschritt und vor dem Reinigungsschritt enthält.

7. Vorrichtung zur Durchführung des Verfahrens nach einem der vorhergehenden Ansprüche, die enthält:
- eine dichte Kammer, die mindestens eine Fotomaske enthält,
- eine Pumpeneinheit, um das Vakuum im Inneren der Kammer herzustellen und aufrechtzuerhalten,
- ein Haltesystem mindestens einer Fotomaske, das im Inneren der dichten Kammer angeordnet ist,
- Infrarotstrahlungseinrichtungen,
- ein Gasinjektionssystem.

8. Vorrichtung nach Anspruch 7, wobei die Innenwände der Kammer die emittierten Wellen reflektieren.

9. Vorrichtung nach einem der Ansprüche 7 und 8, wobei das Gasinjektionssystem mindestens einen Injektor in Form einer Dusche und mindestens einen Partikelfilter enthält.

## Claims

1. Method of manufacturing a photo mask comprising at least one step of cleaning the photo mask, at least one step of placing a protective pellicle (4) onto the photo mask, comprising at least one step of eliminating residue between the cleaning step and the pellicle-placing step, **characterized in that** it comprises:
- the photo mask is placed in a sealed enclosure,
- a low pressure is established in the sealed enclosure by pumping out the gases it contains,
- the photo mask is subjected to infrared radiation of a wavelength that is adjusted, according to the desired depth of desorption, between short wavelengths that act to deep depth and long wavelengths that act at the surface, so as to eliminate ammonia-containing and sulphate-containing residues, the infrared radiation being regulated by chopping so that a photo mask temperature of 300°C is not exceeded,
- the infrared radiation is stopped, leaving the enclosure under low pressure,
- the method waits until the temperature of the photo mask reaches a value of 50°C at the most,
- atmospheric pressure is re-established in the enclosure by injecting a clean non-reactive gas or a neutral gas, and
- the photo mask is extracted from the enclosure.

2. Method according to Claim 1, in which the gases are pumped out for a time of between 20 minutes and 5 hours.

3. Method according to either of Claims 1 and 2, in which a clean gas is introduced at constant flow rate at the same time as the pumping is being carried out.

4. Method according to Claim 3, in which the photo mask is heated to a temperature of between 50°C and 300°C.

5. Method according to one of the preceding claims, in which atmospheric pressure is re-established by injecting non-reactive clean gas.

6. Method according to one of the preceding claims, further involving a step of eliminating ammonia-containing and sulphate-containing residues after a further manufacturing step and before the said cleaning step.

7. Device for implementing the method according to one of the preceding claims, comprising:
- a sealed enclosure containing at least one photo mask,
- a pumping unit for setting up and maintaining a vacuum inside the enclosure,
- a system for holding at least one photo mask, placed inside the sealed enclosure,
- infrared radiation means,
- a gas injection system.

8. Device according to Claim 7, in which the internal walls of the enclosure reflect the emitted waves.

9. Device according to either of Claims 7 and 8, in which the gas injection system comprises at least one injector in the form of a shower head and at least one particulate filter.
